# EUROPEAN PATENT APPLICATION

(11) **EP 3 993 023 A1**
(43) Date of publication of application: **04.05.2022**
(21) Application number: 20832343.6
(22) Date of filing: 28.04.2020
(51) Int. Cl.: H01L 23/02, H01L 23/10, H04N 5/369

(54) **SEMICONDUCTOR PACKAGE AND ELECTRONIC DEVICE**

(30) Priority: 28.06.2019 JP 2019120626
(71) Applicant: Sony Semiconductor Solutions Corporation, Atsugi-shi, Kanagawa 243-0014 (JP)
(72) Inventor: OTSUKA, Yasushi, Atsugi-shi, Kanagawa 243-0014 (JP); SAKAMOTO, Daigo, Kikuchi-gun, Kumamoto 869-1102 (JP)
(74) Representative: Müller Hoffmann & Partner
(86) International application number: PCT/JP2020/018093
(87) International publication number: WO 2020/261754

(57) **Abstract**

A drop in image quality is suppressed while inspecting for misalignment in a semiconductor package in which a solid-state image sensor is connected to a substrate by wires. The semiconductor package includes a solid-state image sensor and a light-blocking film. In the semiconductor package, the solid-state image sensor, which is a rectangle, is provided with a pixel array unit. Additionally, in the semiconductor package, a light guide part and window parts are provided in the light-blocking film. The light guide part guides incident light to the pixel array unit. The window parts are provided in positions corresponding to each of a plurality of corners of the rectangle.

## Description

### [Technical Field]

The present technique relates to semiconductor packages. In particular, the present technique relates to a semiconductor package provided in a solid-state image sensor, and to an electronic device.

### [Background Art]

Conventionally, semiconductor packages are used to facilitate the handling of semiconductor integrated circuits, such as solid-state image sensors, by mounting the semiconductor chip in which the semiconductor integrated circuit is provided on a substrate and sealing the package. For example, a semiconductor package having a structure in which a solid-state image sensor is electrically connected to a substrate by wires and sealed by bonding glass to a glass support member on the substrate has been proposed (see, for example, PTL 1). Then, after sealing with glass, an external camera is used to inspect for debris on the solid-state image sensor, misalignment of the solid-state image sensor, and the like.

### [Citation List]

### [Patent Literature]

[PTL 1]
JP H11-68126 A

### [Summary]

### [Technical Problem]

With the conventional technique described above, a light-blocking film is provided on the glass to block ultraviolet light from reaching an adhesive, which prevents the adhesive from deteriorating due to ultraviolet light. However, in the semiconductor package described above, the region of the light-blocking film does not reach the area above the wires, and thus incident light on the wires is not blocked. There is thus a problem in that flare arises in the image data due to the light reflected by the wires, which reduces the quality of the image data. If the region of the light-blocking film is extended to the area above the wires to prevent flare, the corners of the rectangular solid-state image sensor will not be captured by the external camera, and it will no longer be possible to inspect the solid-state image sensor for misalignment. Thus with the semiconductor package described above, it is difficult to suppress a drop in image quality while inspecting for misalignment.

Having been conceived of in light of such circumstances, an object of the present technique is to suppress a drop in image quality while inspecting for misalignment in a semiconductor package in which a solid-state image sensor is connected to a substrate by wires.

### [Solution to Problem]

The present technique has been conceived of in order to solve the above-described problems, and a first aspect thereof is a semiconductor package including: a solid-state image sensor that is a rectangle and that is provided with a pixel array unit; and a light-blocking film including a light guide part that guides incident light to the pixel array unit, and window parts that are openings provided in positions opposing a plurality of corners of the rectangle. This provides an effect in that incident light to regions aside from the pixel array unit and corners is blocked.

In this first aspect, the plurality of corners may include a pair of opposing corners, and the window parts may be provided in positions corresponding to each of the pair of opposing corners. This provides an effect in that incident light to regions aside from the pixel array unit and the pair of opposing corners is blocked.

In this first aspect, the plurality of corners may be four corners, and four of the window parts may be provided in the light-blocking part. This provides an effect in that incident light to regions aside from the pixel array unit and the four window parts is blocked.

In this first aspect, a shape of each of the window parts may be an L shape. This provides an effect in that light passes to the corners through the L-shaped window parts.

In this first aspect, a shape of each of the window parts may be a circle. This provides an effect in that light passes to the corners through the circular window parts.

In this first aspect, a shape of each of the window parts may be a rectangle. This provides an effect in that light passes to the corners through the rectangular window parts.

In this first aspect, the semiconductor package may further include a substrate connected to the solid-state image sensor by a wire. This provides an effect in that the solid-state image sensor and the substrate are electrically connected.

In this first aspect, the semiconductor package may further include glass and a glass support member that supports the glass, and the light-blocking film may be formed on a surface, of two surfaces of the glass, that faces the solid-state image sensor. This provides an effect in that a gap between a light-receiving surface of the solid-state image sensor and the light-blocking film is relatively small.

In this first aspect, the glass may be bonded to the glass support member by an adhesive, and the light-blocking film may be formed in a region a predetermined distance away from an outer periphery of the glass. This provides an effect in that a region into which the adhesive can escape is formed.

A second aspect of the present technique is an electronic device including: a solid-state image sensor that is a rectangle and that is provided with a pixel array unit; a light-blocking film including a light guide part that guides incident light to the pixel array unit, and window parts that are openings provided in positions opposing a plurality of corners of the rectangle; and a signal processing circuit that executes predetermined signal processing on image data from the solid-state image sensor. This provides an effect in that the image data is processed having blocked incident light to regions aside from the pixel array unit and corners.

### [Brief Description of Drawings]

[Fig. 1] Fig. 1 is a block diagram illustrating an example of the configuration of an electronic device according to a first embodiment of the present technique.
[Fig. 2] Fig. 2 is a cross-sectional view illustrating an example of the configuration of a semiconductor package according to the first embodiment of the present technique.
[Fig. 3] Fig. 3 is an enlarged view of an end part of the semiconductor package according to the first embodiment of the present technique.
[Fig. 4] Fig. 4 is a plan view illustrating an example of the configuration of glass and a solid-state image sensor according to the first embodiment of the present technique.
[Fig. 5] Fig. 5 is a plan view illustrating an example of a light-blocking film having two window parts according to the first embodiment of the present technique.
[Fig. 6] Fig. 6 is an example of a plan view and a cross-sectional view of the glass before a photoresist is applied, according to the first embodiment of the present technique.
[Fig. 7] Fig. 7 is an example of a plan view and a cross-sectional view of the glass after a photoresist is applied, according to the first embodiment of the present technique.
[Fig. 8] Fig. 8 is an example of a plan view and a cross-sectional view of the glass at the time of exposure, according to the first embodiment of the present technique.
[Fig. 9] Fig. 9 is an example of a plan view and a cross-sectional view of the glass after development, according to the first embodiment of the present technique.
[Fig. 10] Fig. 10 is an example of a plan view and a cross-sectional view of the glass after the application of the light-blocking film, according to the first embodiment of the present technique.
[Fig. 11] Fig. 11 is an example of a plan view and a cross-sectional view of the glass after the light-blocking film is removed along with the photoresist, according to the first embodiment of the present technique.
[Fig. 12] Fig. 12 is a flowchart illustrating an example of a method of manufacturing the semiconductor package according to the first embodiment of the present technique.
[Fig. 13] Fig. 13 is a plan view illustrating an example of the light-blocking film according to a first variation on the first embodiment of the present technique.
[Fig. 14] Fig. 14 is a plan view illustrating an example of the light-blocking film according to a second variation on the first embodiment of the present technique.
[Fig. 15] Fig. 15 is a block diagram illustrating an example of the overall configuration of a vehicle control system.
[Fig. 16] Fig. 16 is a descriptive diagram illustrating an example of installation positions of an outside-vehicle information detection unit and an imaging unit.

### [Description of Embodiments]

Hereinafter, modes for carrying out the present technique (hereinafter referred to as embodiments) will be described. The descriptions will be given in the following order.
1. First Embodiment (example in which light guide part and window parts are provided in light-blocking film)
2. First Variation (example in which light guide part and circular window parts are provided in light-blocking film)
3. Second Variation (example in which light guide part and rectangular window parts are provided in light-blocking film)
4. Example of Application in Moving Body

### <1. First Embodiment>

### [Example of Configuration of Electronic Device]

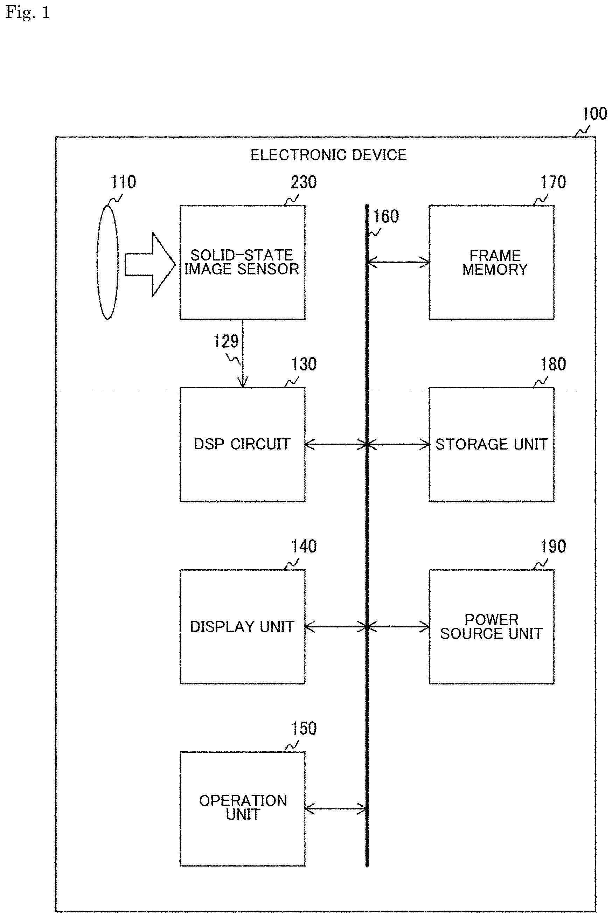

Fig. 1 is a block diagram illustrating an example of the configuration of an electronic device 100 according to a first embodiment of the present technique. This electronic device 100 is a device for capturing image data, and includes an optical unit 110, a solid-state image sensor 230, and a DSP (Digital Signal Processing) circuit 130. The electronic device 100 also includes a display unit 140, an operation unit 150, a bus 160, frame memory 170, a storage unit 180, and a power source unit 190. The electronic device 100 is assumed to be, for example, a digital camera such as a digital still camera, a smartphone, a personal computer, an in-vehicle camera, or the like.

The optical unit 110 focuses light from a subject and guides the light to the solid-state image sensor 230. The solid-state image sensor 230 generates image data through photoelectric conversion in synchronization with a vertical synchronization signal. Here, the vertical synchronization signal is a periodic signal having a predetermined frequency that indicates the timing of image capture. The solid-state image sensor 230 supplies the generated image data to the DSP circuit 130.

The DSP circuit 130 executes predetermined signal processing on the image data from the solid-state image sensor 230. The DSP circuit 130 outputs the processed image data to the frame memory 170 and the like via the bus 160. Note that the DSP circuit 130 is an example of a signal processing circuit described in the patent claims.

The display unit 140 displays the image data. For example, a liquid crystal panel, an organic EL (Electro Luminescence) panel, or the like is assumed as the display unit 140. The operation unit 150 generates operation signals in response to user operations.

The bus 160 is a shared pathway for the optical unit 110, the solid-state image sensor 230, the DSP circuit 130, the display unit 140, the operation unit 150, the frame memory 170, the storage unit 180, and the power source unit 190 to exchange data with each other.

The frame memory 170 holds the image data. The storage unit 180 stores various types of data, such as the image data. The power source unit 190 supplies power to the solid-state image sensor 230, the DSP circuit 130, the display unit 140, and the like.

In the above-described configuration, for example, the solid-state image sensor 230 and the DSP circuit 130 are mounted in a semiconductor package.

### [Example of Configuration of Semiconductor Package]

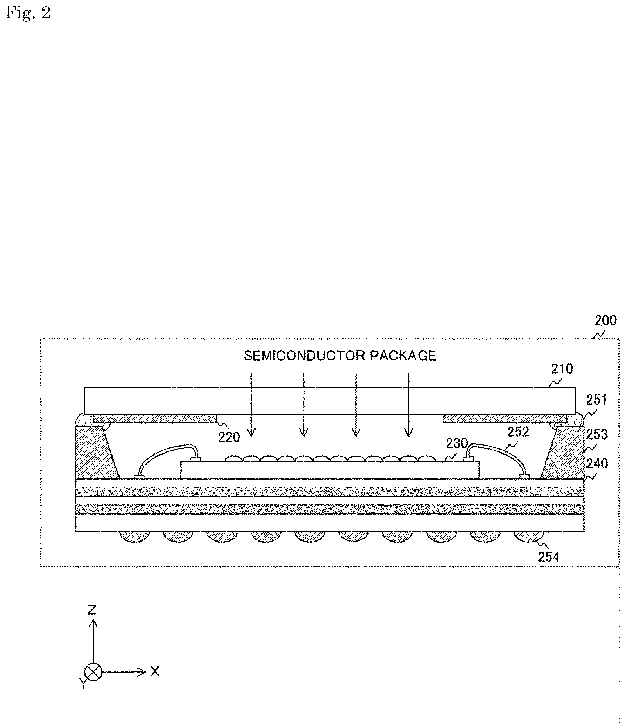

Fig. 2 is a cross-sectional view illustrating an example of the configuration of a semiconductor package 200 according to the first embodiment of the present technique. The semiconductor package 200 includes glass 210, a light-blocking film 220, the solid-state image sensor 230, a substrate 240, a glass support member 253, and solder balls 254.

The glass 210 protects the solid-state image sensor 230. Incident light is incident on one of two surfaces of the glass 210. Noe that the arrows in the drawing indicate the direction of incidence of the incident light.

Hereinafter, of the two surfaces of each of the glass 210, the solid-state image sensor 230, and the substrate 240, the surface on which light is incident will be called a "front surface", and the surface on the opposite side from the front surface will be called a "rear surface". An axis perpendicular to the front surface of the glass 210 will be called the "Z-axis", and a predetermined axis parallel to the front surface of the glass 210 will be called the "X-axis". An axis perpendicular to both the X-axis and the Z-axis will be called the "Y-axis".

The light-blocking film 220 blocks some of the incident light. The light-blocking film 220 is formed on the rear surface of the glass 210.

The solid-state image sensor 230 generates image data through photoelectric conversion. The solid-state image sensor 230 is electrically connected to the substrate 240 by wires 252. Gold wires, for example, are used as the wires 252.

The substrate 240 is a member to which the solid-state image sensor 230 is electrically connected by the wires 252 on the front surface thereof. An organic substrate, a ceramic substrate, or the like can be used as the substrate 240.

The glass support member 253 is a member that supports the glass 210. The glass support member 253 is provided in the periphery of the solid-state image sensor 230 on the front surface of the substrate 240, and has a size in the Z-axis (i.e., a height) that is larger than that of the solid-state image sensor 230. The glass support member 253 is bonded to the glass 210 by adhesive 251. As a result of this bonding, the solid-state image sensor 230 is sealed into a space inside the semiconductor package 200. As such, the semiconductor package 200 has a hollow structure.

The solder balls 254 are used as external terminals to connect the semiconductor package 200 to an external circuit. A predetermined number of the solder balls 254 are provided on the rear surface of the substrate 240. Each of the solder balls 254 is also connected to a circuit, wiring, and the like in the substrate 240.

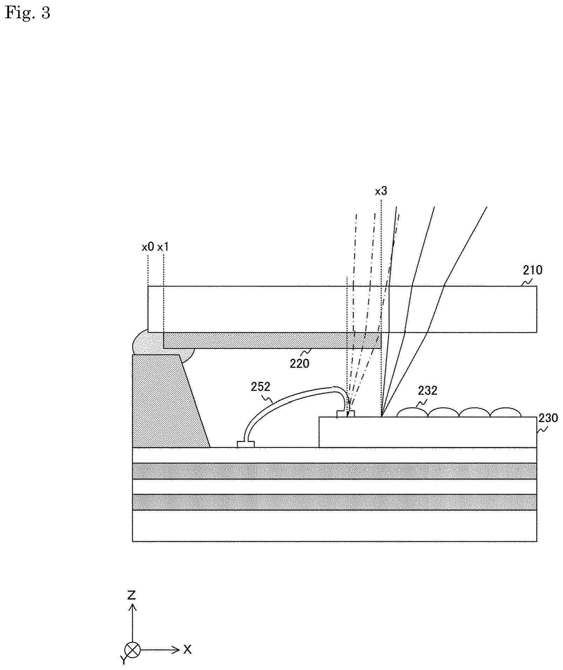

Fig. 3 is an enlarged view of an end part of the semiconductor package 200 according to the first embodiment of the present technique. A position of a left end of the glass 210 in the X-axis direction is represented by x0. As illustrated in Fig. 3, when a position separated by a predetermined distance from a position x0 is taken as x1, in the X-axis direction, the light-blocking film 220 is provided in a range from the position x1 to a position x3. The same applies to a right end in the X-axis direction and the y-axis direction.

In the solid-state image sensor 230, the wires 252 are connected between the position x1 and the position x3. Pixels are arranged on the right side of the position x3, and a microlens 232 is provided above each pixel. The distance from the connection point of the wire 252 to the position x3 is set so that the light does not reach the wire 252. The dot-dash lines in Fig. 3 represent the trajectories of the upper, main, and lower rays of light reaching the wire 252 in a case where the light-blocking film 220 is not provided. The solid lines represent the trajectories of the upper, main, and lower rays of the light reaching the position x3.

By forming the light-blocking film 220 in the range illustrated in Fig. 3, the light-blocking film 220 can block the incident light on the wire 252. Because light does not reach the wire 252, flare in the image data, caused by light reflected by the wire 252, can be prevented. By forming the light-blocking film 220 on the rear surface of the glass 210, a gap between a light-receiving surface of the solid-state image sensor 230 and the light-blocking film 220 can be made narrower than when the light-blocking film 220 is formed on the front surface. This reduces the risk of flare being generated more than when the light-blocking film 220 is formed on the front surface.

On the other hand, the light-blocking film 220 does not block the incident light on the pixels. This makes it possible for the solid-state image sensor 230 to generate image data. If the light-blocking film 220 blocks even some of the light on the pixels, vignetting will occur in the image data, and it is therefore desirable that the distance between the end parts of the light-blocking film 220 (such as the position x3) and the pixels closest to those end parts be at least a set distance such that vignetting does not occur.

Here, assume that an inspection device captures an image of the front surface of the semiconductor package 200 using an external camera or the like and analyzes the obtained image data to inspect for the presence or absence of debris on the solid-state image sensor 230 and for the presence or absence of misalignment of the solid-state image sensor 230. In the inspection for misalignment, for example, the presence or absence of misalignment is determined on the basis of whether deviation of the positions of each of the four corners of the rectangular solid-state image sensor 230 from specified positions is within a predetermined tolerance. Additionally, because debris may adhere to the glass 210 in processes before the bonding, the inspections are performed after the glass 210 is bonded.

### [Example of Configuration of Glass]

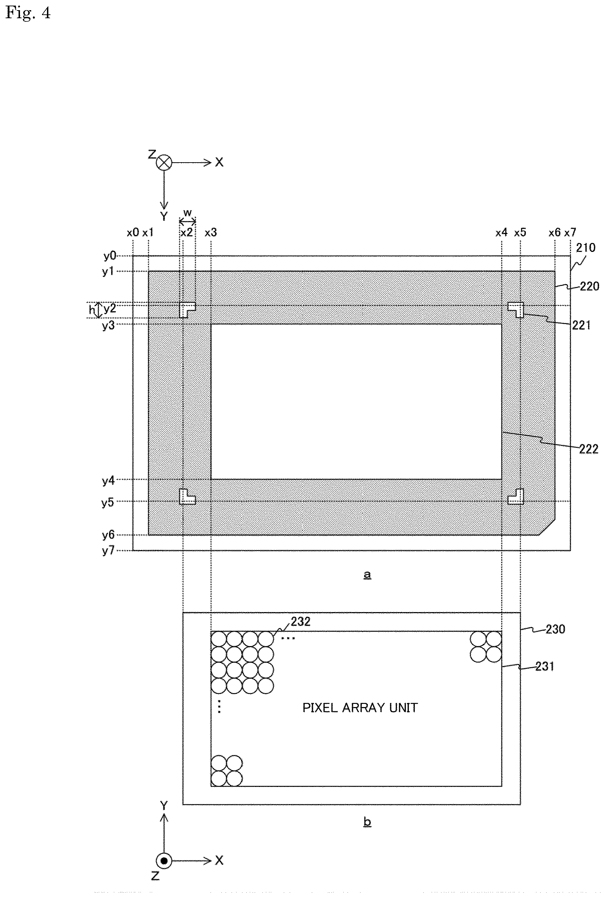

Fig. 4 is a plan view illustrating an example of the configuration of the glass 210 and the solid-state image sensor 230 according to the first embodiment of the present technique. In Fig. 4, a indicates a plan view illustrating an example of the rear surface of the glass 210. b in Fig. 4 is a plan view illustrating an example of the front surface of the solid-state image sensor 230.

As illustrated in a of Fig. 4, the light-blocking film 220 is formed on the rear surface of the glass 210, i.e., on the surface facing the solid-state image sensor 230.

In the X-axis direction, the left end of the glass 210 is assumed to be at x0, and the right end at x7. Additionally, in the Y-axis direction, an upper end of the glass 210 is assumed to be at y0, and a lower end at y7.

The light-blocking film 220 is formed in a region a predetermined distance away from the periphery of the glass 210. For example, in the X-axis direction, the positions that are a predetermined distance away from the left end x0 and the right end x7 are represented by x1 and x6, respectively, and in the Y-axis direction, the positions that are a predetermined distance away from the upper end y0 and the lower end y7 are y1 and y6, respectively. In this case, the left end of the light-blocking film 220 is x1 and the right end is x6. Additionally, the upper end of the light-blocking film 220 is y1 and the lower end is y6.

Here, normally, the glass 210 is split into pieces after the light-blocking film 220 is formed on the glass 210. A thin grinding stone called a blade or a laser is used for the splitting process. If the light-blocking film 220 is formed near the outer periphery of the glass 210, chipping may occur at the edges of the glass 210, or the film may melt and peel off due to heat. However, as illustrated in Fig. 4, if the light-blocking film 220 is not formed in the region near the outer periphery of the glass 210, the adhesive 251 can escape to that region when the glass 210 is split into pieces, making it possible to prevent chipping and peeling. This can also improve the adhesive properties of the adhesive 251. Furthermore, an ultraviolet light-curable resin can be used as the adhesive 251.

As illustrated in b in Fig. 4, the solid-state image sensor 230 is rectangular, and a pixel array unit 231 is provided on the front surface thereof. In the pixel array unit 231, a plurality of pixels are arranged in a two-dimensional grid, and the microlens 232 is provided for each pixel.

Returning to a in Fig. 4, the light-blocking film 220 is provided with a light guide part 222 that guides the incident light to the pixel array unit 231. Assume, for example, that the left end of the pixel array unit 231 is at x3, and the right end is at x4. Assume also that the upper end of the pixel array unit 231 is at y3, and the lower end is at y4. In this case, the left end of the light guide part 222 is at x3 and the right end is at x4. The upper end of the light guide part 222 is at y3 and the lower end is at y4. Here, the distance between positions x3 and x4 is assumed to be shorter than the distance between positions x1 and x6, and the distance between positions y3 and y4 is assumed to be shorter than the distance between positions y1 and y6.

In addition, as illustrated in a in Fig. 4, the light-blocking film 220 is provided with openings as window parts 221 at positions corresponding to each of the plurality of corners of the rectangular solid-state image sensor 230. Assume that, for example, the left end of the solid-state image sensor 230 is at x2 and the right end is at x5. Assume also that the upper end of the solid-state image sensor is at y2 and the lower end is at y5. In this case, a region having a constant area that includes the coordinates of the corners of the solid-state image sensor 230 (x2, y2) and that is smaller than the light guide part 222 is open and used as the window part 221. Window parts 221 are also provided at coordinates (x2, y5), (x5, y2) and (x5, y5), respectively. The shape of each of the window parts 221 is, for example, an L shape, and a size w in the X-axis direction and a size h in the y-axis direction are each, for example, about 200 micrometers (µm).

As illustrated in Fig. 4, in the light-blocking film 220, the light guide part 222 guides the incident light to the pixel array unit 231, and thus the solid-state image sensor 230 can capture image data.

Additionally, by providing the window parts 221 in the light-blocking film 220 at positions opposite the corners of the solid-state image sensor 230, the light-blocking film 220 and the glass 210 can allow the incident light to pass through to the corners. Accordingly, the inspection device can inspect for the present or absence of misalignment of the solid-state image sensor 230 even after the glass 210 has been bonded.

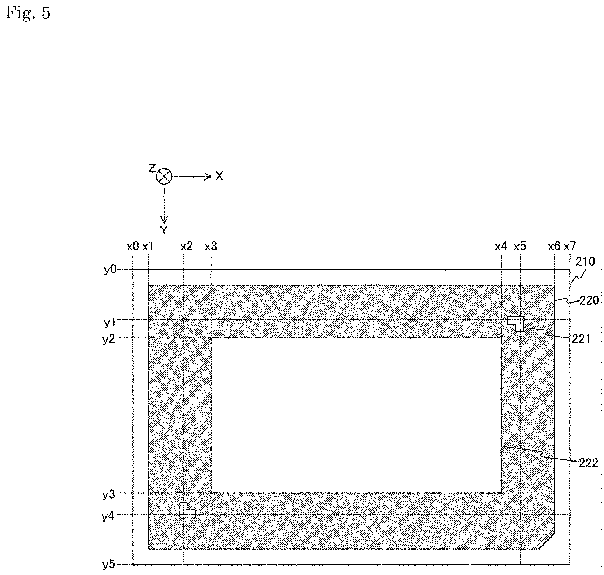

Although the window parts 221 are provided at positions in the light-blocking film 220 corresponding to each of the four corners, the configuration it not limited thereto. As illustrated in Fig. 5, it is also possible to provide a pair of the window parts 221 only in positions, among the four corners, corresponding to opposing corners.

An example of a method for forming the light-blocking film 220 on the glass 210 will be described next.

### [Method for Forming Light-Blocking Film]

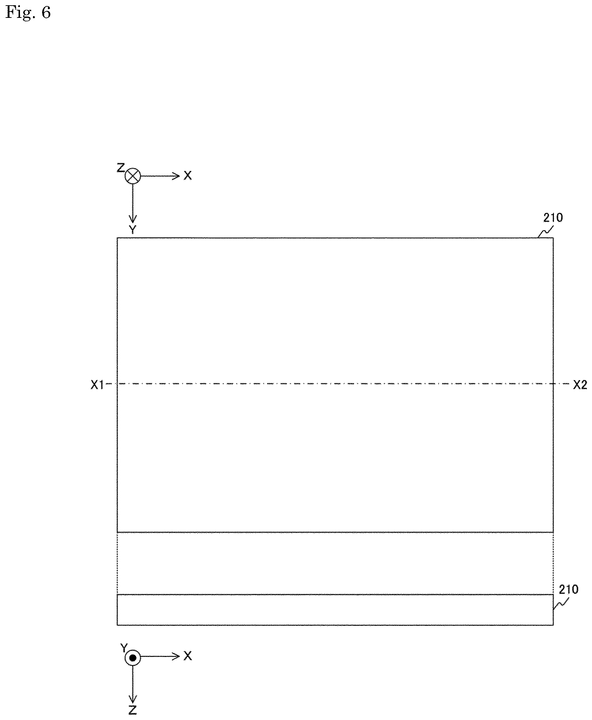

Fig. 6 is an example of a plan view and a cross-sectional view of the glass 210 before a photoresist is applied, according to the first embodiment of the present technique. The plan views from Fig. 6 on illustrate the rear surface of the glass 210. The cross-sectional views from Fig. 6 on illustrate a cross-section cut along ax X1-X2 axis.

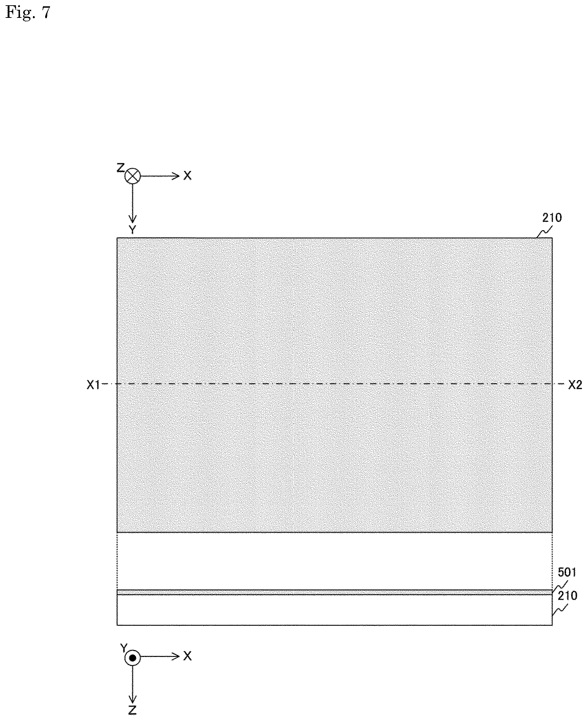

Fig. 7 is an example of a plan view and a cross-sectional view of the glass after the photoresist is applied, according to the first embodiment of the present technique. As illustrated in Fig. 7, a manufacturing system applies a photoresist 501 to the rear surface of the glass 210. A negative UV-curable resin or the like is used as the photoresist 501.

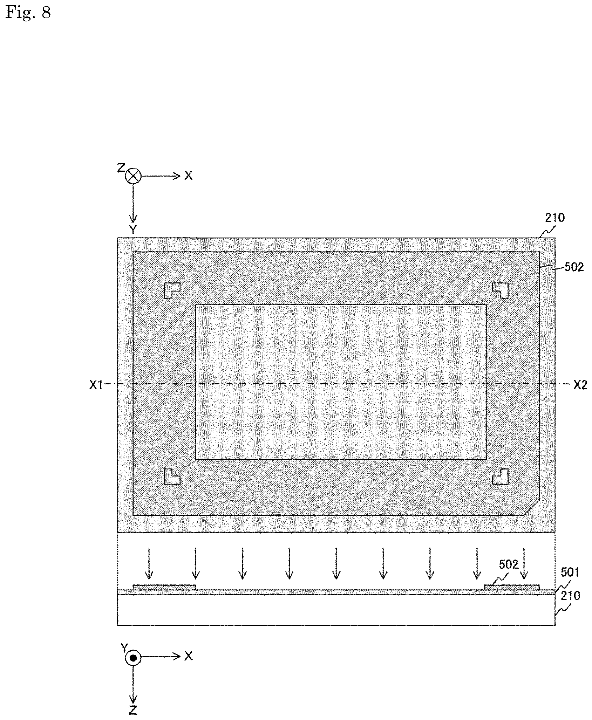

Fig. 8 is an example of a plan view and a cross-sectional view of the glass at the time of exposure, according to the first embodiment of the present technique. As illustrated in Fig. 8, the manufacturing system disposes a mask 502 having the same shape as the light-blocking film 220, and exposes all but the masked parts of the photoresist 501 with ultraviolet light to reduce the solubility thereof. After the exposure, the manufacturing system removes the photoresist 501 from the masked parts by using a developing solution.

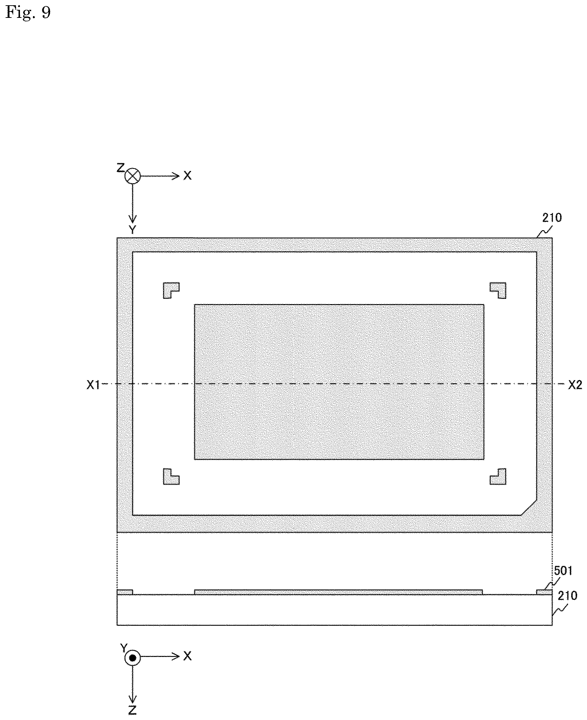

Fig. 9 is an example of a plan view and a cross-sectional view of the glass 210 after development, according to the first embodiment of the present technique. As illustrated in Fig. 9, the unmasked parts of the photoresist 501 remain after the development.

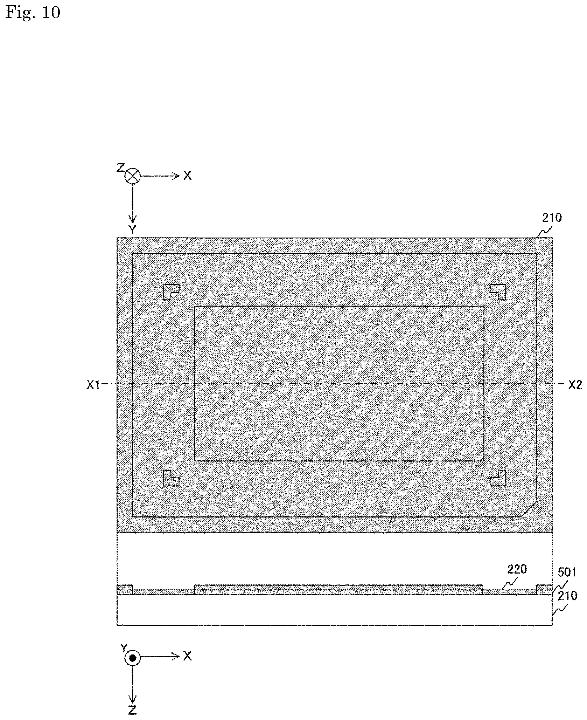

Fig. 10 is an example of a plan view and a cross-sectional view of the glass 210 after the application of the light-blocking film 220, according to the first embodiment of the present technique. As illustrated in Fig. 10, the manufacturing system applies the light-blocking film 220 to the entire rear surface of the glass 210. The light-blocking film 220 requires a high level of dimensional accuracy, and is therefore applied by vapor deposition, sputtering, or the like. By applying the light-blocking film 220, the light-blocking film 220 is layered on each of the regions where the photoresist 501 remains and the regions where there is no photoresist 501.

Here, after the glass 210 is bonded, it is necessary to pass the semiconductor package 200 through a reflow process at a temperature such as 260°C when the package is mounted on an external circuit or the like. If outgas is produced at the light-blocking film 220 or the like during this reflow process, the gas components may adhere to the light-receiving surface or the like of the solid-state image sensor 230 and cause adverse effects. It is therefore desirable that the material of the light-blocking film 220 not be one that produces outgas (such as chrome or an organic film).

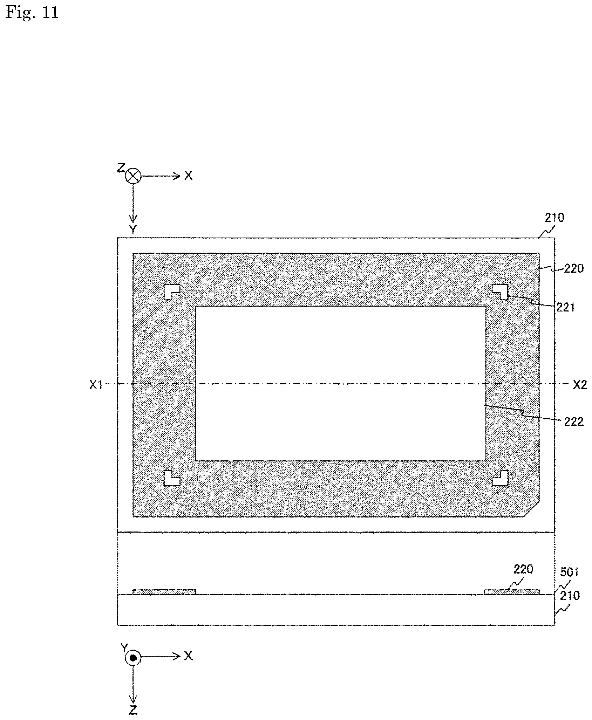

Fig. 11 is an example of a plan view and a cross-sectional view of the glass 210 after the light-blocking film 220 is removed along with the photoresist 501, according to the first embodiment of the present technique. As illustrated in Fig. 11, the manufacturing system removes the photoresist 501 using the developing solution, which can also dissolve the unexposed photoresist 501. The light-blocking film 220 layered on the photoresist 501 is therefore also removed. As a result, a light-blocking film 220 provided with the light guide part 222 and the window parts 221 is formed on the rear surface of the glass 210.

### [Method of Manufacturing Semiconductor Package]

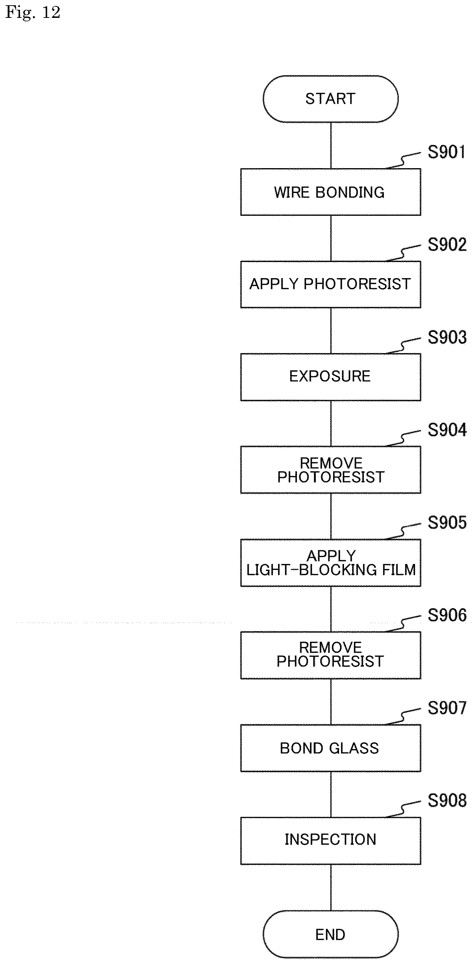

Fig. 12 is a flowchart illustrating an example of a method of manufacturing the semiconductor package 200 according to the first embodiment of the present technique. The manufacturing system first electrically connects the solid-state image sensor 230 to the substrate 240 with the wires 252. In other words, wire bonding is performed (step S901).

The manufacturing system also applies the photoresist to the glass 210 (step S902) and exposes the glass 210 having masked the area where the light-blocking film 220 is to be formed (step S903). The manufacturing system removes the photoresist using the developing solution (step S904) and applies the light-blocking film 220 (step S905). The manufacturing system then removes the photoresist along with the light-blocking film 220 thereon (step S906).

Next, the manufacturing system seals the solid-state image sensor 230 by bonding the glass 210 on which the light-blocking film 220 is formed (step S907). The manufacturing system then inspects for debris and misalignment (step S908). After step S908, the manufacturing system discards defective products according to results of the inspection, and ends the process of manufacturing the semiconductor package 200.

In this manner, according to the first embodiment of the present technique, in the light-blocking film 220, the light guide part 222 guides incident light to the pixel array unit 231, and openings are provided at positions corresponding to each of the plurality of corners to serve as the window parts 221, and thus the positions of the corners can be confirmed through the window parts 221. This enables the inspection device to inspect for misalignment of the solid-state image sensor 230. Additionally, because incident light on the wires in the periphery of the pixel array unit 231 is blocked, a drop in image quality caused by light reflected by the wires can be suppressed.

### [First Variation]

In the foregoing first embodiment, L-shaped window parts 221 are provided in the light-blocking film 220, but the shape of the window parts 221 is not limited to an L shape as long as the positions of the corners can be confirmed. The light-blocking film 220 according to a first variation on the first embodiment differs from the first embodiment in that the window parts 221 are circular.

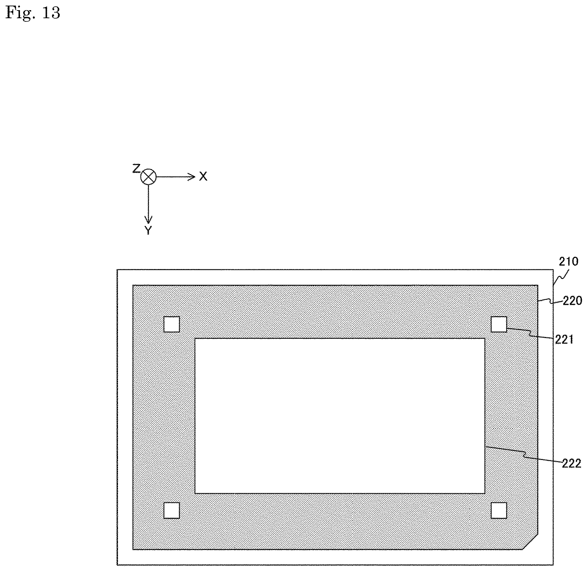

Fig. 13 is a plan view illustrating an example of the light-blocking film 220 according to the first variation on the first embodiment of the present technique. Circular window parts 221 are provided, in positions corresponding to the corners, in the light-blocking film 220 according to the first variation on the first embodiment.

In this manner, according to the first variation on the first embodiment of the present technique, circular window parts 221 are provided at positions opposing the corners, and thus the positions of the corners can be confirmed through the window parts 221.

### [Second Variation]

In the foregoing first embodiment, L-shaped window parts 221 are provided in the light-blocking film 220, but the shape of the window parts 221 is not limited to an L shape as long as the positions of the corners can be confirmed. The light-blocking film 220 according to a second variation on the first embodiment differs from the first embodiment in that the window parts 221 are rectangular.

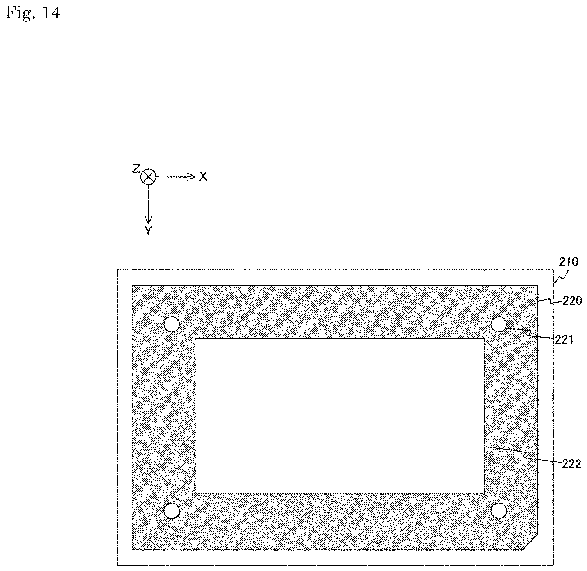

Fig. 14 is a plan view illustrating an example of the light-blocking film 220 according to the second variation on the first embodiment of the present technique. Rectangular window parts 221 are provided, in positions corresponding to the corners, in the light-blocking film 220 according to the second variation on the first embodiment.

In this manner, according to the second variation on the first embodiment of the present technique, rectangular window parts 221 are provided at positions opposing the corners, and thus the positions of the corners can be confirmed through the window parts 221.

### <Example of Application in Moving Body>

The technique according to the present disclosure (the present technique) can be applied in various products. For example, the technique according to the present disclosure may be realized as a device mounted on any type of moving body such as an automobile, an electric automobile, a hybrid electric automobile, a motorcycle, a bicycle, a personal mobility device, an airplane, a drone, a ship, a robot, or the like.

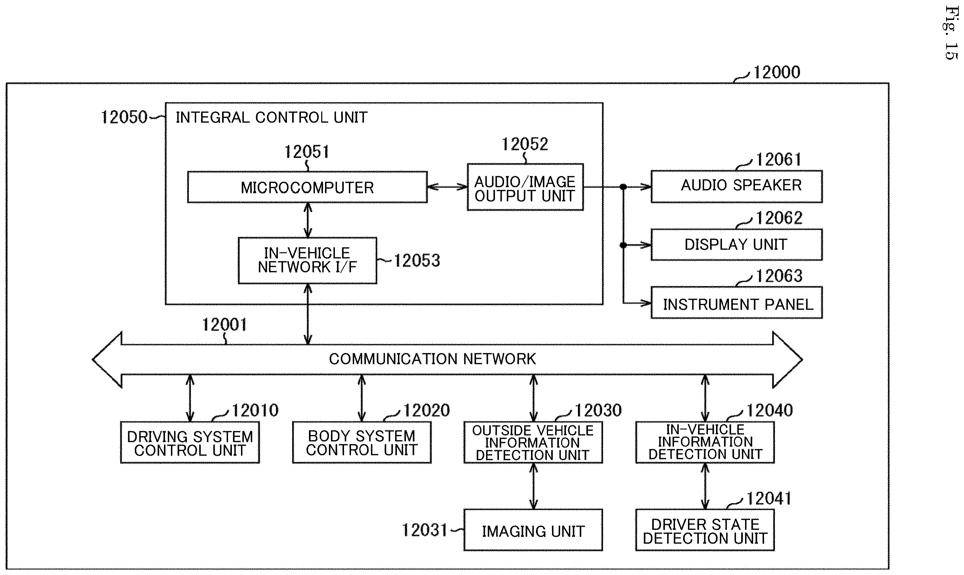

Fig. 15 is a block diagram illustrating an example of the overall configuration of a vehicle control system serving as an example of a moving body control system to which the technique according to the present disclosure can be applied.

A vehicle control system 12000 includes a plurality of electronic control units connected to each other through a communication network 12001. In the example illustrated in Fig. 15, the vehicle control system 12000 includes a driving system control unit 12010, a body system control unit 12020, an outside vehicle information detection unit 12030, an in-vehicle information detection unit 12040, and an integral control unit 12050. In addition, a microcomputer 12051, an audio/image output unit 12052, and an in-vehicle network interface (I/F) 12053 are illustrated in the drawing as functional configurations of the integral control unit 12050.

The driving system control unit 12010 controls operations of devices related to a drive system of a vehicle in accordance with various programs. For example, the driving system control unit 12010 functions as a driving force generator for generating a driving force of a vehicle such as an internal combustion engine or a driving motor, a driving force transmission mechanism for transmitting a driving force to wheels, a steering mechanism for adjusting a turning angle of a vehicle, and a control device such as a braking device that generates a braking force of a vehicle.

The body system control unit 12020 controls operations of various devices mounted on a vehicle body in accordance with various programs. For example, the body system control unit 12020 functions as various types of control devices such as a keyless entry system, a smart key system, a power window device, or various lamps such as a headlamp, a back lamp, a brake lamp, a turn signal, or a fog lamp. In this case, radio waves transmitted from a portable device that substitutes for a key or signals of various switches can be input to the body system control unit 12020. The body system control unit 12020 receives inputs of the radio waves or the signals and controls a door locking device, a power window device, lamps, and the like of the vehicle.

The outside vehicle information detection unit 12030 detects information on the outside of the vehicle on which the vehicle control system 12000 is mounted. For example, an imaging unit 12031 is connected to the outside vehicle information detection unit 12030. The outside vehicle information detection unit 12030 causes the imaging unit 12031 to capture an image of the outside of a vehicle and receives the captured image. The outside vehicle information detection unit 12030 may perform object detection processing or distance detection processing for persons, vehicles, obstacles, signs, or text on a road surface on the basis of the received image.

The imaging unit 12031 is an optical sensor that receives light and outputs an electrical signal corresponding to the amount of light received. The imaging unit 12031 can also output the electrical signal as an image and output rangefinding information. In addition, light received by the imaging unit 12031 may be visible light, or may be invisible light such as infrared light.

The in-vehicle information detection unit 12040 detects information on the inside of the vehicle. For example, a driver state detection unit 12041 that detects a driver's state is connected to the in-vehicle information detection unit 12040. The driver state detection unit 12041 includes, for example, a camera that captures an image of the driver, and the in-vehicle information detection unit 12040 may calculate a degree of fatigue or concentration of the driver or may determine whether or not the driver is dozing on the basis of detection information input from the driver state detection unit 12041.

The microcomputer 12051 can calculate a control target value of the driving force generator, the steering mechanism, or the braking device on the basis of information on the inside and outside of the vehicle acquired by the outside vehicle information detection unit 12030 or the in-vehicle information detection unit 12040, and can output a control command to the driving system control unit 12010. For example, the microcomputer 12051 can perform coordinated control for the purpose of realizing a function of an advanced driver assistance system (ADAS) including vehicle collision avoidance, shock alleviation, following travel based on an inter-vehicle distance, cruise control, vehicle collision warning, vehicle lane departure warning, or the like.

Further, the microcomputer 12051 can perform coordinated control for the purpose of automated driving or the like in which autonomous travel is performed without depending on an operation of a driver by controlling the driving force generator, the steering mechanism, the braking device, and the like on the basis of information regarding the vicinity of the vehicle acquired by the outside vehicle information detection unit 12030 or the in-vehicle information detection unit 12040.

Further, the microcomputer 12051 can output a control command to the body system control unit 12020 on the basis of information regarding the vehicle exterior acquired by the outside vehicle information detection unit 12030. For example, the microcomputer 12051 can perform coordinated control for the purpose of achieving anti-glare such as switching of a high beam to a low beam by controlling the head lamp in accordance with a position of a preceding vehicle or an oncoming vehicle detected by the outside vehicle information detection unit 12030.

The audio/image output unit 12052 transmits an output signal of at least one of audio and an image to an output device capable of visually or audibly notifying an occupant of a vehicle or the outside of the vehicle of information. In the example illustrated in Fig. 15, an audio speaker 12061, a display unit 12062, and an instrument panel 12063 are illustrated as output devices. The display unit 12062 may include, for example, at least one of an on-board display and a heads-up display.

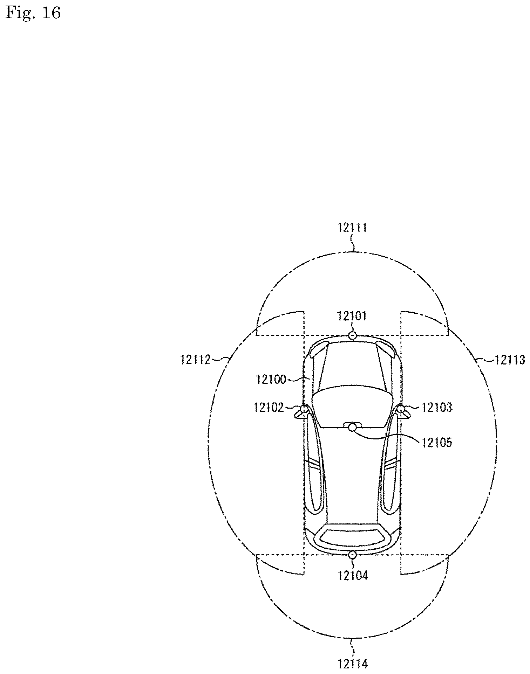

Fig. 16 is a diagram illustrating an example of the installation position of the imaging unit 12031.

In Fig. 16, imaging units 12101, 12102, 12103, 12104, and 12105 are provided as the imaging unit 12031.

The imaging units 12101, 12102, 12103, 12104, and 12105 are provided at positions such as a front nose, side mirrors, a rear bumper, a back door, and an upper part of a windshield in a vehicle interior of a vehicle 12100, for example. The imaging unit 12101 provided at the front nose and the imaging unit 12105 provided at an upper part of the windshield inside the vehicle mainly obtain an image of the area in front of the vehicle 12100. The imaging units 12102 and 12103 provided in the side mirrors mainly obtain images of the areas to the sides of the vehicle 12100. The imaging unit 12104 provided in the rear bumper or the back door mainly obtains an image of the area to the rear of the vehicle 12100. The imaging unit 12105 provided in the upper part of the windshield in the vehicle cabin is mainly used for detection of a preceding vehicle, a pedestrian, an obstacle, a traffic light, a traffic sign, a lane, or the like.

Note that Fig. 16 illustrates an example of imaging ranges of the imaging units 12101 to 12104. An imaging range 12111 indicates an imaging range of the imaging unit 12101 provided at the front nose, imaging ranges 12112 and 12113 respectively indicate the imaging ranges of the imaging units 12102 and 12103 provided at the side mirrors, and an imaging range 12114 indicates the imaging range of the imaging unit 12104 provided at the rear bumper or the back door. For example, a bird's-eye view image of the vehicle 12100 as viewed from above can be obtained by superimposition of image data captured by the imaging units 12101 to 12104.

At least one of the imaging units 12101 to 12104 may have a function for obtaining distance information. For example, at least one of the imaging units 12101 to 12104 may be a stereo camera constituted by a plurality of image sensors or may be an imaging element having pixels for phase difference detection.

For example, the microcomputer 12051 can obtain a distance to each of three-dimensional objects in the imaging range 12111 to 12114 and a temporal change in the distance (a relative speed with respect to the vehicle 12100) on the basis of the distance information obtained from the imaging units 12101 to 12104, to thereby extract, particularly, the closest three-dimensional object in the path of travel of the vehicle 12100, which is a three-dimensional object traveling at a predetermined speed (for example, 0 km/h or more) in the substantially same direction as the vehicle 12100, as a preceding vehicle. Furthermore, the microcomputer 12051 can set an inter-vehicle distance to be secured in front of the preceding vehicle in advance, and perform automatic brake control (including following stop control), automatic acceleration control (including following start control), and the like. Thus, it is possible to perform cooperative control for the purpose of, for example, autonomous driving in which the vehicle autonomously travels without requiring the driver to perform operations.

For example, the microcomputer 12051 can classify three-dimensional object data related to a three-dimensional object into a two-wheeled vehicle, a standard vehicle, a large vehicle, a pedestrian, an electric pole, and other three-dimensional objects on the basis of distance information obtained from the imaging units 12101 to 12104, and can use the extracted three-dimensional object data for automatic avoidance of obstacles. For example, the microcomputer 12051 classifies obstacles in the vicinity of the vehicle 12100 into obstacles that can be visually recognized by the driver of the vehicle 12100 and obstacles that are difficult to visually recognize. Then, the microcomputer 12051 can determine a risk of collision indicating the degree of risk of collision with each obstacle, and can perform driving assistance for collision avoidance by outputting a warning to a driver through the audio speaker 12061 or the display unit 12062 and performing forced deceleration or avoidance steering through the driving system control unit 12010 when the risk of collision has a value equal to or greater than a set value and there is a possibility of collision.

At least one of the imaging units 12101 to 12104 may be an infrared camera that detects infrared light. For example, the microcomputer 12051 can recognize a pedestrian by determining whether or not a pedestrian is present in images captured by the imaging units 12101 to 12104. Such recognition of a pedestrian is performed by, for example, a procedure of extracting a feature point in captured images of the imaging units 12101 to 12104 serving as infrared cameras, and a procedure of performing pattern matching processing on a series of feature points indicating the contour of an object to determine whether or not the object is a pedestrian. When the microcomputer 12051 determines that a pedestrian is present in the captured images of the imaging units 12101 to 12104 and recognizes the pedestrian, the audio/image output unit 12052 controls the display unit 12062 so that a square contour line for emphasis is superimposed on the recognized pedestrian and is displayed. In addition, the audio/image output unit 12052 may control the display unit 12062 so that an icon or the like indicating a pedestrian is displayed at a desired position.

An example of a vehicle control system to which the technique according to the present disclosure is applied has been described above. The technique according to the present disclosure may be applied, for example, to the imaging unit 12031 and the like among the configurations described above. Specifically, the electronic device 100 in Fig. 1 can be applied to the imaging unit 12031. By applying the technique according to the present disclosure to the imaging unit 12031, flare can be suppressed and a clearer captured image can be obtained, which makes it possible to reduce driver fatigue.

The foregoing embodiment is a mode for carrying out the present technique and the items in the embodiment have the respective correspondence relationships with the specific items of the invention in the claims. Similarly, the specific items of the invention in the claims have the respective correspondence relationships with the matters having items with the same names in the embodiment of the present technique. Here, the present technique is not limited to the embodiment, and various modifications of the embodiment can be made within the scope of the present technique without departing from the essential spirit of the present technique.

The advantageous effects in the embodiments described in the present specification are merely exemplary and are not limited, and other advantageous effects may be obtained.

The present technique can be configured as follows.
(1) A semiconductor package including: a solid-state image sensor that is a rectangle and that is provided with a pixel array unit; and a light-blocking film including a light guide part that guides incident light to the pixel array unit, and window parts that are openings provided in positions opposing a plurality of corners of the rectangle.
(2) The semiconductor package according to (1), wherein the plurality of corners include a pair of opposing corners, and the window parts are provided in positions corresponding to each of the pair of opposing corners.
(3) The semiconductor package according to (1), wherein the plurality of corners are four corners, and four of the window parts are provided in the light-blocking part.
(4) The semiconductor package according to any one of (1) to (3), wherein a shape of each of the window parts is an L shape.
(5) The semiconductor package according to any one of (1) to (3), wherein a shape of each of the window parts is a circle.
(6) The semiconductor package according to any one of (1) to (3), wherein a shape of each of the window parts is a rectangle.
(7) The semiconductor package according to any one of (1) to (6), further including: a substrate connected to the solid-state image sensor by a wire.
(8) The semiconductor package according to any one of (1) to (7), further including glass and a glass support member that supports the glass, wherein the light-blocking film is formed on a surface, of two surfaces of the glass, that faces the solid-state image sensor.
(9) The semiconductor package according to (8), wherein the glass is bonded to the glass support member by an adhesive, and the light-blocking film is formed in a region a predetermined distance away from an outer periphery of the glass.
(10) An electronic device including: a solid-state image sensor that is a rectangle and that is provided with a pixel array unit; a light-blocking film including a light guide part that guides incident light to the pixel array unit, and window parts that are openings provided in positions opposing a plurality of corners of the rectangle; and a signal processing circuit that executes predetermined signal processing on image data from the solid-state image sensor.

### [Reference Signs List]

- 100: Electronic device
- 110: Optical unit
- 130: DSP (Digital Signal Processing) circuit
- 140: Display unit
- 150: Operation unit
- 160: Bus
- 170: Frame memory
- 180: Storage unit
- 190: Power source unit
- 200: Semiconductor package
- 210: Glass
- 220: Light-blocking film
- 221: Window part
- 222: Light guide part
- 230: Solid-state image sensor
- 231: Pixel array unit
- 232: Microlens
- 240: Substrate
- 251: Adhesive
- 252: Wire
- 253: Glass support member
- 254: Solder ball
- 12031: Imaging unit

## Claims

1. A semiconductor package comprising:
a solid-state image sensor that is a rectangle and that is provided with a pixel array unit; and
a light-blocking film including a light guide part that guides incident light to the pixel array unit, and window parts that are openings provided in positions opposing a plurality of corners of the rectangle.

2. The semiconductor package according to claim 1, wherein
the plurality of corners include a pair of opposing corners, and
the window parts are provided in positions corresponding to each of the pair of opposing corners.

3. The semiconductor package according to claim 1, wherein
the plurality of corners are four corners, and
four of the window parts are provided in the light-blocking part.

4. The semiconductor package according to claim 1, wherein a shape of each of the window parts is an L shape.

5. The semiconductor package according to claim 1, wherein a shape of each of the window parts is a circle.

6. The semiconductor package according to claim 1, wherein a shape of each of the window parts is a rectangle.

7. The semiconductor package according to claim 1, further comprising a substrate connected to the solid-state image sensor by a wire.

8. The semiconductor package according to claim 1, further comprising:
glass; and
a glass support member that supports the glass, wherein the light-blocking film is formed on a surface, of two surfaces of the glass, that faces the solid-state image sensor.

9. The semiconductor package according to claim 8, wherein
the glass is bonded to the glass support member by an adhesive, and
the light-blocking film is formed in a region a predetermined distance away from an outer periphery of the glass.

10. An electronic device comprising:
a solid-state image sensor that is a rectangle and that is provided with a pixel array unit;
a light-blocking film including a light guide part that guides incident light to the pixel array unit, and window parts that are openings provided in positions opposing a plurality of corners of the rectangle; and
a signal processing circuit that executes predetermined signal processing on image data from the solid-state image sensor.
